(19) **Europäisches Patentamt**
**European Patent Office**
**Office européen des brevets**

(11) **EP 4 407 333 A1**

(12) **EUROPEAN PATENT APPLICATION**
published in accordance with Art. 153(4) EPC

(43) Date of publication:
**31.07.2024 Bulletin 2024/31**

(21) Application number: **22894283.5**

(22) Date of filing: **05.07.2022**

(51) International Patent Classification (IPC):
***G01R 33/02*** *(2006.01)*    ***G01R 33/09*** *(2006.01)*

(86) International application number:
**PCT/CN2022/103840**

(87) International publication number:
**WO 2023/087740 (25.05.2023 Gazette 2023/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.11.2021 CN 202111360274**

(71) Applicant: **Huawei Digital Power Technologies
Co., Ltd.
Shenzhen, Guangdong 518043 (CN)**

(72) Inventors:
• **YI, Liqiong**
**Shenzhen, Guangdong 518043 (CN)**
• **YANG, Zezhou**
**Shenzhen, Guangdong 518043 (CN)**
• **HU, Xiaolu**
**Shenzhen, Guangdong 518043 (CN)**
• **CHEN, Shaoxian**
**Shenzhen, Guangdong 518043 (CN)**

(74) Representative: **Epping - Hermann - Fischer
Patentanwaltsgesellschaft mbH
Schloßschmidstraße 5
80639 München (DE)**

(54) **MAGNETIC SENSOR AND ELECTRONIC DEVICE**

(57)      A magnetic sensor and an electronic device are provided. The magnetic sensor includes a printed circuit board (310) and a tunnel magneto-resistance element (320). The printed circuit board (310) includes a target trace (311). When the tunnel magneto-resistance element (320) is installed, the tunnel magneto-resistance element (320) is installed right above or right below the target trace (311), and a ratio of a distance D between a detection unit in the tunnel magneto-resistance element (320) and an edge on a side that is of the target trace (311) and that is closest to the tunnel magneto-resistance element (320) to a width W of the target trace (311) is between 3.0% and 20.0%. In this way, a current value in the target trace (311) detected by the tunnel magneto-resistance element (320) does not change or changes slightly as frequency of an electrical signal in the target trace (311) changes, so that the tunnel magneto-resistance element (320) can accurately detect the current value of the electrical signal in the target trace (311). This increases a range of a measurement bandwidth of the tunnel magneto-resistance element (320).

FIG. 3

## Description

This application claims priority to Chinese Patent Application No. 202111360274.8, filed with the China National Intellectual Property Administration on November 17, 2021 and entitled "MAGNETIC SENSOR AND ELECTRONIC DEVICE", which is incorporated herein by reference in its entirety.

## TECHNICAL FIELD

The present invention relates to the field of electronics and electrical technologies, and in particular, to a magnetic sensor and an electronic device.

## BACKGROUND

A current sensor may detect information about a current in a circuit, and convert, based on a specific rule, the information about the current into an electrical signal or information in another form that meets a requirement of a specific standard, to meet requirements such as information transmission, processing, storage, display, recording, and control. There are a plurality of existing types of current sensors, including common shunt resistors, current transformers, Hall current sensors, magnetoresistive effect current sensors, magnetostrictive current sensors, light current sensors, and the like.

With the development of integrated circuit technologies, a large quantity of components such as circuits, transistors, and resistors may be integrated together to form a small circuit board. This improves integration of an electronic device and reduces hardware costs and power consumption costs of the electronic device. A printed circuit board (printed circuit board, PCB) is used as an example. A large quantity of traces are arranged in the PCB, and various components are electrically connected to each other by using the traces. However, a current that flows through each trace in the PCB is low in general, and is about dozens of milliamperes, or even lower. As a result, it is difficult to detect the current in the trace. Therefore, it is important to select a current sensor with high detection accuracy for the traces in the PCB.

## SUMMARY

To resolve the foregoing problem, embodiments of this application provide a magnetic sensor and an electronic device. A TMR element is disposed on an outer surface of a PCB. When the TMR element is located right above or right below a detected target trace, and a distance between the TMR element and an edge on a side that is of the target trace and that is closest to the TMR element satisfies D = 0.1584W - 0.1209, a magnetic field detected by the TMR element does not change or changes slightly as frequency of an electrical signal in the target trace changes. In this way, a current value in the target trace can be accurately measured. This increases a range of a measurement bandwidth of the TMR element.

Therefore, the following technical solutions are used in embodiments of this application.

According to a first aspect, an embodiment of this application provides a magnetic sensor, including: a printed circuit board, including a target trace configured to electrically connect components to each other; and a tunnel magneto-resistance element, fastened to an outer surface of the printed circuit board and configured to detect a current value in the target trace. The tunnel magneto-resistance element is located on a normal line on a side surface of the target trace. A ratio of a distance D between a detection unit in the tunnel magneto-resistance element and an edge on a side that is of the target trace and that is closest to the tunnel magneto-resistance element to a width W of the target trace is between 3.0% and 20.0%. The detection unit is configured to detect magnetic induction intensity. The width of the target trace is a length in a direction perpendicular to a current flow direction on the target trace.

In this implementation, generally, the current value in the target trace detected by the tunnel magneto-resistance element changes as frequency of an electrical signal in the target trace changes. However, a distance between the tunnel magneto-resistance element and the target trace affects an amplitude in which the current value detected by the tunnel magneto-resistance element changes with the frequency of the electrical signal in the target trace. Therefore, when the tunnel magneto-resistance element is installed, the tunnel magneto-resistance element may be installed right above or right below the target trace, and the ratio of the distance D between the detection unit in the tunnel magneto-resistance element and the edge on the side that is of the target trace and that is closest to the tunnel magneto-resistance element to the width W of the target trace is between 3.0% and 20.0%. Therefore, the current value in the target trace detected by the tunnel magneto-resistance element does not change or changes slightly as the frequency of the electrical signal in the target trace changes, so that the tunnel magneto-resistance element can accurately detect the current value of the electrical signal in the target trace. This increases a range of a measurement bandwidth of the tunnel magneto-resistance element.

In an implementation, the tunnel magneto-resistance element is located on the normal line on the side surface of the target trace. The distance D between the detection unit in the tunnel magneto-resistance element and the edge on the side that is of the target trace and that is closest to the tunnel magneto-resistance element satisfies D = 0.1584W - 0.1209, where D and Ware in units of mm, and D and W are in units of mm.

In this implementation, it is verified by a large quantity of experiments that when the tunnel magneto-resistance element is located on the normal line on the side surface of the target trace, and the distance D between the detection unit in the tunnel magneto-resistance element and the edge on the side that is of the target trace and that is closest to the tunnel magneto-resistance element is D = 0.1584W - 0.1209, a change of the amplitude in which the current value detected by the tunnel magneto-resistance element changes with the frequency of the electrical signal in the target trace is the smallest. Therefore, the tunnel magneto-resistance element can accurately detect the current value of the electrical signal in the target trace.

In an implementation, a width of the tunnel magneto-resistance element is less than the width of the target trace. The width of the tunnel magneto-resistance element is a length in the direction perpendicular to the current flow direction on the target trace.

In this implementation, the width of the target trace detected by the tunnel magneto-resistance element is usually greater than the width of the tunnel magneto-resistance element. If a part of the tunnel magneto-resistance element protrudes from an edge of the target trace, another component and trace affect a detection result of the tunnel magneto-resistance element. This reduces accuracy of current detection.

In an implementation, the width w of the tunnel magneto-resistance element satisfies w < W - 2D, where D and Ware in units of mm.

In this implementation, a specified distance is required to be reserved between an ideal installation position of the tunnel magneto-resistance element and the edge on the side that is of the target trace and that is closest to the tunnel magneto-resistance element. Therefore, the width of the target trace detected by the tunnel magneto-resistance element is not only greater than the width of the tunnel magneto-resistance element, but also greater than a sum of the width of the tunnel magneto-resistance element and a distance twice as long as the reserved distance. This ensures that no part of the tunnel magneto-resistance element protrudes from the edge of the target trace. This reduces the accuracy of the current detection.

In an implementation, in a direction of the normal line on the side surface of the target trace, a distance between the tunnel magneto-resistance element and the target trace is greater than zero.

In this implementation, a height h between the tunnel magneto-resistance element and the target trace is generally greater than 0. If the height h between the tunnel magneto-resistance element and the target trace is equal to 0, in other words, the tunnel magneto-resistance element is embedded into the target trace, this installation causes high costs of the electronic device.

In an implementation, the target trace is made of a graphite material.

In this implementation, the target trace on the printed circuit board may be made of graphite, to effectively prevent skin effect from being generated in the target trace. Therefore, the accuracy of measuring the current value in the target trace by the tunnel magneto-resistance element is further improved.

In an implementation, the magnetic sensor further includes a shielding assembly, disposed on a surface of a side that is of the tunnel magneto-resistance element and that is away from the printed circuit board, and configured to shield magnetic fields generated by a trace other than the target trace and another component.

In this implementation, the shielding assembly is generally disposed on the surface of the side that is of the tunnel magneto-resistance element and that is away from the printed circuit board. Therefore, an external magnetic field is shielded and does not affect the detection result of the tunnel magneto-resistance element.

In an implementation, the shielding assembly is of a comb structure.

In this implementation, the shielding assembly is generally of the comb structure. A gap exists between teeth of the comb structure. In this way, a path of an eddy current of a shielding body in a high-frequency magnetic field can be cut off, to suppress generation of eddy current effect in the shielding body. In this way, a surrounding magnetic field is not distorted or is distorted slightly, so that the shielding assembly can effectively shield the external magnetic field, and the detection result of the tunnel magneto-resistance element is not affected.

In an implementation, a size of the shielding assembly is greater than a size of the tunnel magneto-resistance element.

In this implementation, the size of the shielding assembly needs to be greater than the size of the tunnel magneto-resistance element, to prevent the external magnetic field on a side surface of the tunnel magneto-resistance element from affecting the detection result of the tunnel magneto-resistance element when the shielding assembly is arranged on the tunnel magneto-resistance element.

According to a second aspect, an embodiment of this application provides an electronic device, including at least one magnetic sensor according to the possible implementations of the first aspect.

BRIEF DESCRIPTION OF DRAWINGS

The following briefly describes accompanying drawings used in descriptions of embodiments or a conventional technology.

FIG. 1(a) is a diagram of magnetic field distribution when a low-frequency electrical signal is input to a PCB trace in the conventional technology;
FIG. 1(b) is a diagram of magnetic field distribution when a high-frequency electrical signal is input to a PCB trace in the conventional technology;
FIG. 2 is a diagram of magnetic field distribution at position points A and B when electrical signals at different frequency are input to a PCB trace in the conventional technology;
FIG. 3 is a schematic top view of a structure of a magnetic sensor according to an embodiment of this application;
FIG. 4 is a schematic sectional view of a structure of a magnetic sensor according to an embodiment of this application;
FIG. 5(a) is a schematic diagram of an example in which magnetization directions of two magnet layers are parallel;
FIG. 5(b) is a schematic diagram of an example in which magnetization directions of two magnet layers are antiparallel;
FIG. 6 is an experimental diagram of a relationship between changes of a magnetic field detected by a TMR element and frequency of an electrical signal in a target trace when a width of the target trace is 4 mm and the TMR element is at different distances from an edge on a side that is of the target trace and that is closest to the TMR element according to an embodiment of this application;
FIG. 7 is an experimental diagram of corresponding flatness when a width of a target trace is 4 mm and a TMR element is at different distances from an edge on a side that is of the target trace and that is closest to the TMR element according to an embodiment of this application;
FIG. 8 is an experimental diagram of current distribution obtained through simulation when graphite and copper are used as materials of traces in a PCB according to an embodiment of this application; and
FIG. 9 is a schematic diagram of a shielding assembly of a comb structure according to an embodiment of this application.

## DESCRIPTION OF EMBODIMENTS

The following describes the technical solutions of embodiments of this application with reference to the accompanying drawings in embodiments of this application.

In the descriptions of this application, directions or position relationships indicated by the terms "center", "up", "down", "front", "rear", "left", "right", "vertical", "horizontal", "top", "bottom", "inside", "outside", and the like are based on the directions or position relationships shown in the accompanying drawings, and are merely intended to describe this application and simplify the descriptions, but are not intended to indicate or imply that an apparatus or a component shall have a specific direction or be formed and operated in a specific direction, and therefore shall not be understood as a limitation on this application.

In the descriptions of this application, it should be noted that, unless otherwise clearly specified and limited, terms "mount", "link", and "connect" should be understood in a broad sense, for example, may mean a fixed connection, may be a detachable connection, or may be a butt joint connection or an integrated connection. Persons of ordinary skill in the art can understand specific meanings of the foregoing terms in this application based on specific cases.

In the descriptions of this specification, the described specific features, structures, materials, or characteristics may be combined in a proper manner in any one or more of embodiments or examples.

In modern industry and electronic products, a Hall current sensor is the most widely used magnetic sensor. The magnetic sensor generally detects physical parameters such as a current, a position, and a direction by using sensing magnetic field strength. A sensitive element of the magnetic sensor for receiving a magnetic field signal may be a Hall element, an anisotropic magneto-resistance (anisotropic magneto-resistance, AMR) element, a giant magneto-resistance (giant magneto-resistance, GMR) element, a tunnel magneto-resistance (tunnel magneto-resistance, TMR) element, or the like.

For a magnetic sensor using the Hall element as the sensitive element, because operating currents of components in an existing electronic device are low to a milliampere level or lower, a magnetic ring structure needs to be added to the magnetic sensor. A surrounding magnetic field is amplified by using the magnetic ring structure, to improve sensitivity of the Hall element to output an electrical signal. However, adding the magnetic ring structure to the magnetic sensor increases a volume and a weight of the magnetic sensor. The Hall element has defects such as high power consumption and poor linearity. This causes poor performance of the magnetic sensor.

For a magnetic sensor using the AMR element as the sensitive element, if the sensitive element in the magnetic sensor is an AMR component, a set/reset coil needs to be disposed in the magnetic sensor to perform a preset/reset operation on the AMR element. Although sensitivity of the AMR element is much higher than that of the Hall element, a linear range of the AMR element is narrower. The set/reset coil is added, and this makes a manufacturing process of the magnetic sensor complex, and causes high costs of the magnetic sensor.

For a magnetic sensor using the GMR element as the sensitive element, if the GMR element is selected as the sensitive element, when the magnetic sensor is compared with the magnetic sensor including the Hall element, the magnetic sensor has higher sensitivity, but a narrower linear range. This causes poor performance of the magnetic sensor.

The TMR element is a new type of magnetoresistive effect sensor that has been used in the industry in recent years. The TMR element is initially used in a magnetic read/write head of a hard disk drive. Therefore, precision, accuracy, and service life reliability of the TMR element for magnetic field detection are high. The TMR element detects a magnetic field generated by a current on a copper bar or a conductive wire, and calculates the current by using a chip. Compared with the magnetic sensor including the Hall element, the magnetic sensor including the TMR element has better temperature stability, higher sensitivity, lower power consumption, and better linearity, and does not need the additional magnetic ring structure. Compared with the magnetic sensor including the AMR element, the magnetic sensor including the TMR element has better temperature stability, higher sensitivity and a wider linear range, and does not need the additional set/reset coil structure. Compared with the magnetic sensor including the GMR element, the magnetic sensor including the TMR element has better temperature stability, higher sensitivity, lower power consumption, and a wider linear range.

Table 1 shows comparisons between the magnetic sensors including the Hall element, the AMR element, the GMR element, and the TMR element. The comparisons are performed based on six technical parameters: power consumption, a size, sensitivity, a linear range, resolution, and a temperature feature. In this way, the advantages of the TMR element can be more intuitively seen.

The table is specifically as follows:

**Table 1 Comparisons between technical parameters of various magnetic sensors**

| Type | Power consumption (mA) | Size (mm) | Sensitivity (mV/V/Oe) | Linear range (Oe) | Resolution (mOe) | Temperature performance (°C) |
|---|---|---|---|---|---|---|
| Hall element | 5 to 20 | 1×1 | 0.05 | 1 to 1000 | 500 | < 150 |
| AMR element | 1 to 10 | 1×1 | 1 | 0.001 to 10 | 0.1 | < 150 |
| GMR element | 1 to 10 | 2×2 | 3 | 0.1 to 30 | 2 | < 150 |
| TMR element | 0.001 to 0.01 | 0.5×0.5 | 20 | 0.001 to 200 | 0.1 | < 200 |

As can be learned from Table 1 that, compared with other magnetic sensors, the magnetic sensor including the TMR element has noticeable advantages in the six aspects: the power consumption, the size, the sensitivity, the linear range, the resolution, and the temperature feature.

For a surface-mount TMR magnetic sensor, the TMR element is surface-mounted on the trace in the PCB. The surface-mount TMR magnetic sensor relates to an open magnetic circuit detection mode, and measurement precision is easily affected by an external factor. When there is an alternating current or an alternating electromagnetic field in a conductor, the current in the conductor is not evenly distributed. The current is concentrated in the "skin" of the conductor. In other words, the current is concentrated at a thin surface layer of the conductor. Current density is increasingly higher near the surface of the conductor, and the current is actually small inside the conductor. Therefore, resistance of the conductor increases and a power loss increases accordingly. This phenomenon is called skin effect (skin effect).

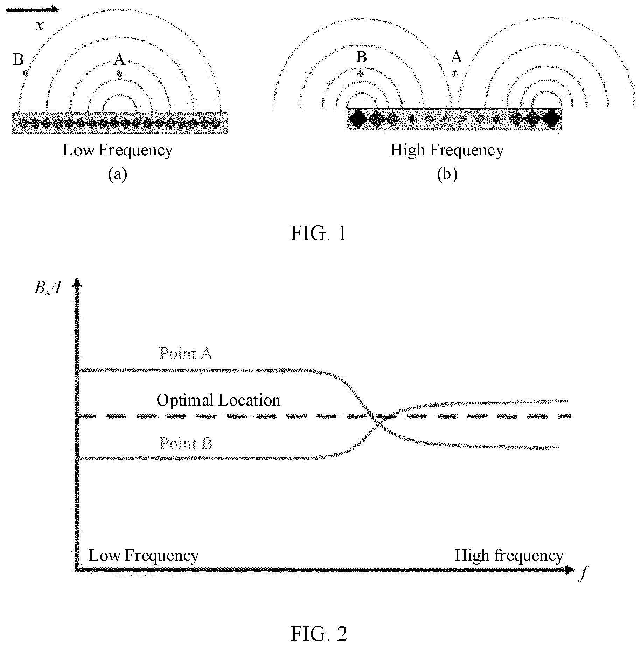

In the conventional technology, as shown in (a) in FIG. 1, if a rate of current change (di/dt) in a trace is close to zero when a low-frequency electrical signal is input into the trace in a PCB, it may be considered that current distribution is even, and no skin effect occurs. As shown in (b) in FIG. 1, if a high-frequency electrical signal is input into the trace in the PCB, due to skin effect, a magnetic field generated in the trace by the high-frequency electrical signal is in a central region of the trace, and largest electromotive force is obtained through induction. The electromotive force generates an induced current in a closed circuit, and the induced current is the largest at the center of the trace. Because a direction of the induced current is opposite to a direction of an original current, and the induced current becomes larger as the frequency increases, the current is very small or zero at a central position of the trace in the PCB, and the current is large at two sides. This causes uneven distribution of the magnetic field generated around the trace.

After electrical signals at different frequency are input into the trace in the PCB, at two measurement position points A and B around the trace, relationships between magnetic field strength detected at the two position points and frequency of the electrical signals are shown in FIG. 2. Because a to-be-detected current generally includes abundant harmonic content, a proper installation position needs to be found, to allow magnetic induction intensity B generated by currents of different frequency to basically remain unchanged. This ensures a measurement bandwidth of the TMR element.

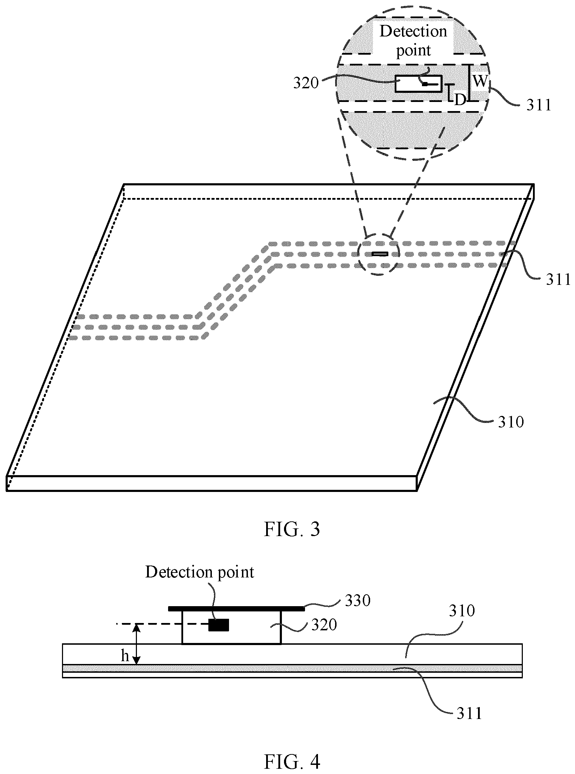

FIG. 3 and FIG. 4 are schematic diagrams of a structure of a magnetic sensor according to an embodiment of this application. As shown in the figures, the magnetic sensor 300 includes a PCB 310 and a TMR element 320. A large quantity of traces are arranged in the PCB 310 to electrically connect components to each other. The TMR element 320 is generally arranged on an outer surface of the PCB 310. A relationship between the TMR element 320 and a to-be-detected trace (referred to as a "target trace 311") is that the TMR element 320 and the target trace 311 are located in a direction of a normal line on the outer surface of the PCB 310. The PCB generally consists of connecting wires and an isolation material. When the PCB is manufactured, the connecting wires may be laid on a plane, and then an isolation material is sprayed on the connecting wires. In this way, the connecting wires are isolated from each other. Then, another layer of connecting wires is laid over the sprayed isolation material, and the isolation material is then sprayed on the connecting wires. The rest may be deduced by analogy, and the PCB having a plurality of layers of connecting wires may be manufactured. The connecting wires in the isolation material are generally referred to as "traces".

When electrical signals are input into the TMR element 320 and the target trace 311, because the TMR element 320 and the target trace 311 are located in the direction of the normal line on the outer surface of the PCB 310, the TMR element 320 and the target trace 311 form a TMR element 320-isolation material-target trace 311 structure in the isolation material of the PCB 310. This generates tunnel magnetoresistive effect. Tunnel magnetoresistive effect is effect in which in a ferromagnetic material-insulator thin film-ferromagnetic material, a tunneling resistance value varies with a change of a relative direction of ferromagnetic materials on both sides. Tunnel magnetoresistive effect has unique advantages of large magnetoresistive effect and high magnetic field sensitivity. Therefore, a wide application prospect is achieved.

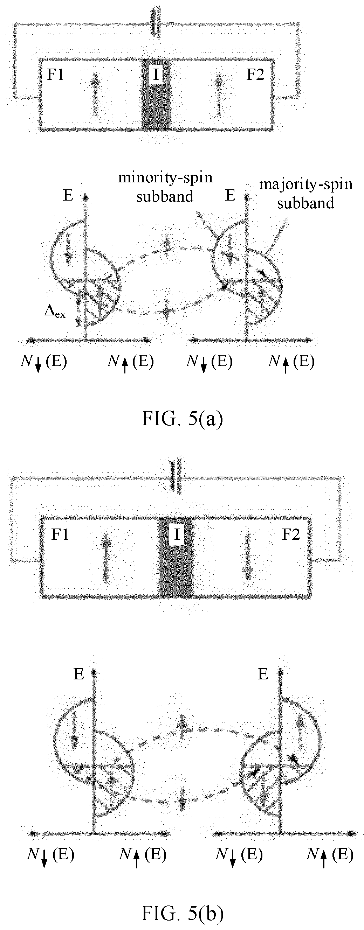

From a classical physics point of view, in a sandwich structure of a ferromagnetic layer (F1)+an insulation layer (I)+a ferromagnetic layer (F2), electrons cannot pass through magnetic layers. However, this phenomenon can be perfectly explained by using quantum mechanics. As shown in FIG. 5(a), when magnetization directions of the two ferromagnetic layers are parallel, electrons at majority-spin subbands enter empty states of majority-spin subbands at another magnetic layer, and electrons at minority-spin subbands also enter empty states of minority-spin subbands at the another magnetic layer. A total tunneling current is large. In this case, the TMR element 320 is in a low-resistance state. As shown in FIG. 5(b), when the magnetization directions of the two magnet layers are antiparallel, the opposite is true. To be specific, the electrons at the majority-spin subbands enter the empty states of the minority-spin subbands at the another magnetic layer, and the electrons at the minority-spin subbands also enter the empty states of the majority-spin subbands at the another magnetic layer. In this case, the tunneling current is small, and the TMR element 320 is in a high-resistance state. It can be learned that both the tunneling current and the tunneling resistance depend on the relative orientation of magnetization intensity of the two ferromagnetic layers. When the magnetization direction changes, the tunneling resistance changes. Therefore, this is referred to as tunnel magnetoresistive effect.

In this application, the TMR element 320 may calculate, by using a principle that a magnetic field change causes a change of magnetic resistance, a change of a magnetic field around the TMR element 320 by detecting a change of the magnetic resistance, to calculate a current value in the target trace 311. However, if the high-frequency electrical signal is input into the target trace 311, skin effect occurs in the target trace 311. In this way, a magnetic field generated by the target trace 311 changes as the frequency of the input electrical signal changes. As a result, the TMR element 320 cannot accurately measure the current value in the target trace 311, and therefore, the range of the measurement bandwidth of the TMR element 320 is greatly reduced.

FIG. 2 is a diagram of magnetic field distribution at the position points A and B when electrical signals at different frequency are input in the conventional technology. It can be learned from FIG. 2 that, if a detection point is at the position point A, as the frequency of the input electrical signal in the target trace 311 increases, a detected magnetic field first remains unchanged, then gradually decreases within a frequency band, and then remains unchanged again after the detected magnetic field decreases to a specific value. If a detection point is at the position point B, as the frequency of the input electrical signal in the target trace 311 increases, a detected magnetic field first remains unchanged, then gradually increases within a frequency band, and then remains unchanged again after the detected magnetic field increases to a specific value. It is conceivable that at a position between the position point A and the position point B, as the frequency of the input electrical signal in the target trace 311 increases, a detected additional magnetic field always remains unchanged or changes within a very small range, so that the TMR element 320 can accurately measure the current value in the target trace 311. In this way, the range of the measurement bandwidth of the TMR element 320 is improved.

In this embodiment of this application, the target trace 311 is located at a middle position of the PCB 310, and the TMR element 320 may be fastened to the outer surface of the PCB 310 through welding, bonding, or the like. The position at which the TMR element 320 is fastened to the PCB 310 is right above or right below the target trace 311 from a top view shown in FIG. 3. A ratio of a distance D between a detection unit in the TMR element 320 and an edge on a side that is of the target trace 311 and that is closest to the TMR element 320 to a width W of the target trace 311 is between 3.0% and 20.0%. Therefore, the current value in the target trace detected by the tunnel magneto-resistance element does not change or changes slightly as the frequency of the electrical signal in the target trace changes, so that the tunnel magneto-resistance element can accurately detect the current value of the electrical signal in the target trace. This increases the range of the measurement bandwidth of the tunnel magneto-resistance element. For example, it is verified by a large quantity of experiments that when the TMR element 320 is located right above or right below the target trace 311, and the distance D between the detection unit in the TMR element 320 and the edge on the side that is of the target trace 311 and that is closest to the TMR element 320 satisfies the relationship shown in formula (1), a change of the amplitude in which the current value detected by the TMR element 320 changes with the frequency of the electrical signal in the target trace 311 is the smallest. Therefore, the TMR element 320 can accurately detect the current value of the electrical signal in the target trace 311. The formula (1) is specifically as follows:

$$D = 0.1584W - 0.1209 \quad (1)$$

D represents the distance between the detection unit in the TMR element 320 and the edge on the side that is of the target trace 311 and that is closest to the TMR element 320, W is the width of the target trace 3 11, and D and W are in units of mm.

In this application, the width of the target trace 311 detected by the TMR element 320 is generally between 1 mm and 40 mm. If the width of the target trace 311 is less than 1 mm, the width of the target trace 311 may be less than the width of the TMR element 320. This causes reduced detection accuracy of the TMR element 320. If the width of the target trace 311 is greater than 40 mm, the target trace 311 occupies a large area of the PCB, and causes an integration level of the PCB to reduce. For example, if the width W of the target trace 311 is between 1 mm and 40 mm, the following may be calculated according to the formula (1). When the width W of the target trace 311 is equal to 1 mm, and the distance D between the detection unit in the TMR element 320 and the edge on the side that is of the target trace 311 and that is closest to the TMR element 320 is equal to 0.038 mm, the ratio of the distance D between the detection unit in the TMR element 320 and the edge on the side that is of the target trace 311 and that is closest to the TMR element 320 to the width W of the target trace 311 is 3.75%. When the width W of the target trace 311 is equal to 40 mm, and the distance D between the detection unit in the TMR element 320 and the edge on the side that is of the target trace 311 and that is closest to the TMR element 320 is equal to 6.215 mm, the ratio of the distance D between the detection unit in the TMR element 320 and the edge on the side that is of the target trace 311 and that is closest to the TMR element 320 to the width W of the target trace 311 is 15.54%.

When the TMR element 320 is arranged on the outer surface of the PCB 310, an installation error is inevitable. Therefore, a deviation caused by the installation error needs to be considered. When the width W of the target trace 311 is equal to 1 mm, and the distance D between the detection unit in the TMR element 320 and the edge on the side that is of the target trace 311 and that is closest to the TMR element 320 is equal to 0.038 mm, if an error of the distance D is allowed to be within ±0.008 mm, a shortest distance D between the detection unit in the TMR element 320 and the edge on the side that is of the target trace 311 and that is closest to the TMR element 320 is equal to 0.03 mm. In this case, a smallest value of the ratio of the distance D between the detection unit in the TMR element 320 and the edge on the side that is of the target trace 311 and that is closest to the TMR element 320 to the width W of the target trace 311 is 3.0%. When the width W of the target trace 311 is equal to 40 mm, and the distance D between the detection unit in the TMR element 320 and the edge on the side that is of the target trace 311 and that is closest to the TMR element 320 is equal to 6.215 mm, if an error of the distance D is allowed to be within ±1.785 mm, a longest distance D between the detection unit in the TMR element 320 and the edge on the side that is of the target trace 311 and that is closest to the TMR element 320 is equal to 8.0 mm. In this case, a largest value of the ratio of the distance D between the detection unit in the TMR element 320 and the edge on the side that is of the target trace 311 and that is closest to the TMR element 320 to the width W of the target trace 311 is 20.0%.

In an experimental simulation process of this application, the traces are arranged in the selected PCB 310, and the width W of the target trace 311 is equal to 4 mm. The TMR element 320 is fastened to the outer surface of the PCB 310 in a surface mounting manner. From a top view, the TMR element 320 is located right above the target trace. The distance D between the detection unit in the TMR element 320 and the edge on the side that is of the target trace 311 and that is closest to the TMR element 320 is 0.1584 × 4 - 0.1209 ~ 0.5 mm. The ratio of the distance D between the detection unit in the TMR element 320 and the edge on the side that is of the target trace 311 and that is closest to the TMR element 320 to the width W of the target trace 311 is 12.82%. A height distance h between the detection unit in the TMR element 320 and the target trace 311 is equal to 1.2 mm.

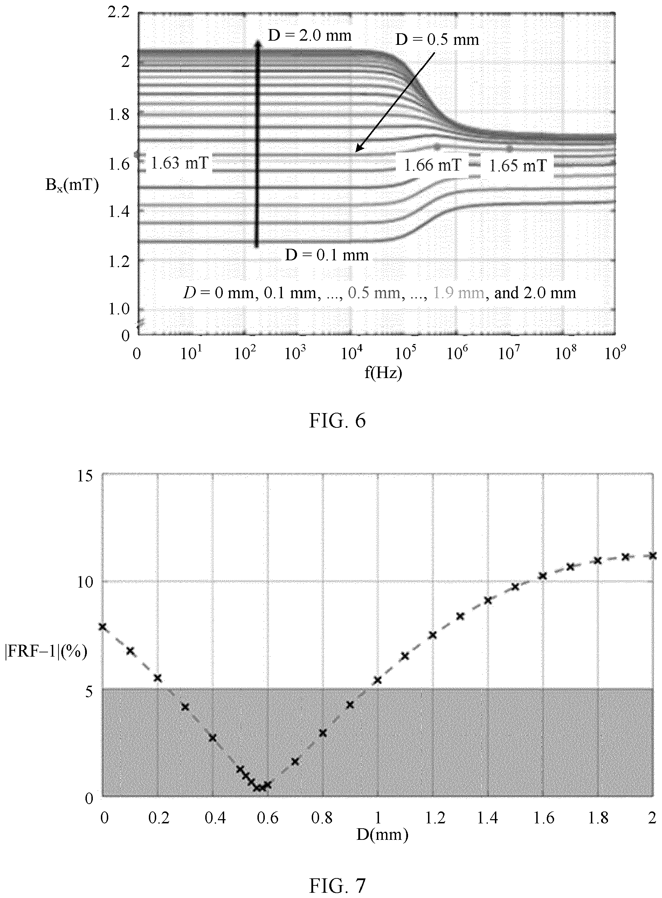

In a finite element simulation process, different distances 0, 0.1 mm, 0.2 mm, ..., 0.5 mm, ..., and 2.0 mm are selected as the distance D between the detection unit in the TMR element 320 and the edge on the side that is of the target trace 311 and that is closest to the TMR element 320. A result shown in FIG. 6 is obtained. In a curve with D = 0.5 mm, a smallest magnetic field B detected by the TMR element 320 is equal to 1.63 mT, a greatest magnetic field B is 1.66 mT, and flatness $\eta$ is (1.66-1.63)/1.63 = 1.8%. Compared with a magnetic field, a frequency change, and flatness in a case in which the distance is of another value, the magnetic field detected by the TMR element 320 is most stable, the frequency of the input electrical signal in the target trace 311 changes least, and the flatness is also the smallest in a case in which the distance D between the detection unit in the TMR element 320 and the edge on the side that is of the target trace 311 and that is closest to the TMR element 320 is equal to 0.5 mm. In this way, it is verified that when the distance between the TMR element 320 and the edge on the side that is of the target trace 311 and that is closest to the TMR element 320 satisfies the formula (1), the installation position of the TMR element 320 is most ideal, and the detected magnetic field is most stable.

Because the ideal installation position determined according to the formula (1) for the TMR element 320 is at an mm level, a requirement on a product manufacturing process is high. Generally, to reduce the costs, a deviation within a specific range for the installation position of the TMR element 320 is acceptable. Optionally, when the flatness $\eta$ is less than 5%, it may be considered that a magnetic field change range is very small. In this case, the installation position of the TMR element 320 is the ideal position. Refer to FIG. 7. When the value of D is closer to 0.5 mm, the flatness $\eta$ is smaller. When the value D is farther from 0.5 mm, the flatness $\eta$ is larger. If it is set that the TMR element 320 can be considered as being installed at the ideal position when $\eta < 5\%$, it is acceptable that the distance D between the detection unit in the TMR element 320 and the edge on the side that is of the target trace 311 and that is closest to the TMR element 320 is between 0.2 mm and 0.8 mm. Therefore, in an installation process, the installation position of the TMR element 320 may have a deviation of 0.3 mm relative to the ideal position D = 0.1584W - 0.1209. In this way, a product manufacturing difficulty is reduced, and the product costs are reduced. In addition, in this case, the ratio of the distance D between the detection unit in the TMR element 320 and the edge on the side that is of the target trace 311 and that is closest to the TMR element 320 to the width W of the target trace 311 is between 5.0% and 20.0%, and this falls within the range set according to this application.

In this application, it can be learned from the formula (1) that the ideal position at which the TMR element 320 is disposed on the PCB 310 is not related to the height h between the TMR element 320 and the target trace 311. Therefore, a thickness of the PCB 310 in this application may be any value. This is not limited in this application. Preferably, the height h between the TMR element 320 and the target trace 311 is generally greater than 0. If the height h between the TMR element 320 and the target trace 311 is equal to 0, in other words, the TMR element 320 is embedded into the target trace 320, this installation causes high costs of the electronic device.

Refer to FIG. 3. The width of the TMR element 320, that is, a side length in a direction parallel to the width of the target trace 311, is less than the width of the target trace 311. From a top view, the TMR element 320 does not protrude from a region in which the target trace 311 is located. Generally, if the TMR element 320 is located right above or right below the target trace 311, the TMR element 320 is far away from another trace. A magnetic field generated by the another trace slightly affects a detection result of the TMR element 320. If a part of the TMR element 320 protrudes from the region in which the target trace 311 is located, or is even superimposed on the another trace from a top view, a magnetic field generated by the another trace greatly affects a detection result of the TMR element 320. In this case, the current value in the target trace detected by the TMR element 320 is inaccurate. Optionally, a relationship between the width of the TMR element 320 and the width of the target trace 311 needs to meet a relationship shown in a formula (2). The formula (2) is specifically as follows:

$$w < W - 2D \quad (2)$$

w represents the width of the TMR element 320, and W represents the width of the target trace 311.

In this embodiment of this application, the TMR element of the magnetic sensor is disposed on the outer surface of the PCB. When the TMR element is located right above or right below the detected target trace, and the distance between the TMR element and the edge on the side that is of the target trace and that is closest to the TMR element satisfies D = 0.1584W - 0.1209, the magnetic field detected by the TMR element does not change or changes slightly as the frequency of the electrical signal in the target trace changes. Therefore, the current value in the target trace can be accurately measured. This increases the range of the measurement bandwidth of the TMR element.

In the magnetic sensor 300 set forth in this application, the target trace 311 on the PCB 310 may be made of graphite, to effectively prevent skin effect from being generated in the target trace 311. Therefore, the accuracy of measuring the current value in the target trace 311 by the TMR element 320 is further improved. For example, generation of skin effect in the target trace 311 is generally related to the frequency of the electrical signal, magnetic permeability, and electrical conductivity. The relationship is specifically as follows:

$$\delta = \sqrt{\frac{2}{\omega\mu\gamma}} \quad (3)$$

$\omega$ represents the frequency of the electrical signal in the trace, $\mu$ represents the magnetic permeability of the trace, and $\gamma$ represents the electrical conductivity of the trace.

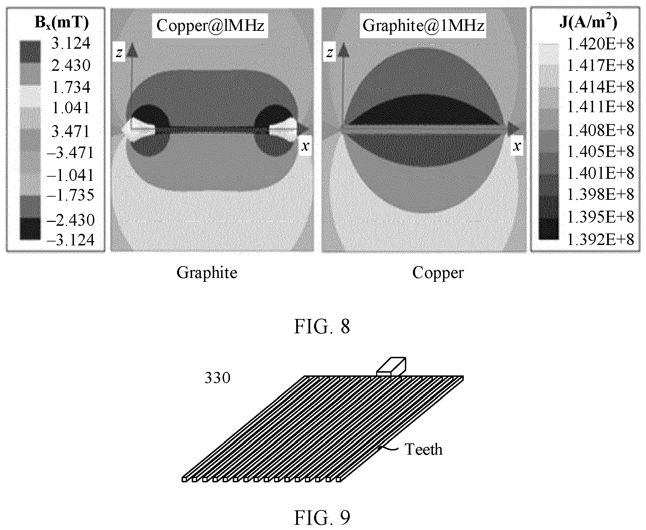

It can be learned from the formula (3) that, when the frequency $\omega$ remains unchanged, if the magnetic permeability $\mu$ and the electrical conductivity $\gamma$ are reduced, the generation of skin effect in the trace can be effectively suppressed. If graphite is selected as the material of the trace, electrical conductivity $\gamma$ of graphite is equal to $7 \times 10^4$ S/m, and is smaller than electrical conductivity $\gamma$ of a metal material, that is, $\delta_{graphite}$ is greater than $\delta_{copper}$. Therefore, better suppression of the generation of skin effect is achieved in the target trace 311 formed by graphite. In the finite element simulation process, in this application, graphite and copper elements are separately used as materials of the traces. An experimental simulation is performed on the manufactured PCB, and a simulation result shown in FIG. 8 is obtained. When the frequency of the electrical signal is within 1 MHz, a current in the graphite trace is evenly distributed in the trace, and a current in the copper trace is unevenly distributed. It can be learned that the suppression of the generation of skin effect in the trace is more noticeable in the graphite trace.

Refer to FIG. 9. Graphite is used as the material of the traces. When the TMR element 320 is at different positions, in other words, when the value of D is equal to 0, 0.5 mm, 0.6 mm, 1 mm, 1.5 mm and 2 mm, a simulation diagram in which the magnetic field detected by the TMR element 320 changes as the frequency of the electrical signal in the trace changes is compared with the simulation result in FIG. 6. When the frequency of the electrical signal is within 10 MHz, flatness of a change of the magnetic field detected by the magnetic sensor in which graphite is used as the material of the traces is better.

The magnetic sensor 300 set forth in this application further includes a shielding assembly 330. The shielding assembly 330 is generally disposed on a surface of a side that is of the TMR element 320 and that is away from the PCB 310. Therefore, an external magnetic field is shielded and does not affect the detection result of the TMR element 320. For example, as shown in FIG. 9, the shielding assembly 330 is generally of a comb structure. An area of the comb structure is greater than an area of the surface of the side that is of the TMR element 320 and that is away from the PCB 310. In this way, the shielding assembly 330 can effectively shield the external magnetic field, and the external magnetic field does not affect the detection result of the TMR element 320. In addition, if a shielding body with a complete structure is used, eddy current effect is generated in the shielding body, and a surrounding magnetic field is severely distorted. This affects the detection result of the TMR element 320. However, a shielding body with the comb structure is used. In the comb structure, a gap exists between teeth that play a shielding function. Therefore, a path of the eddy current of the shielding body in a high-frequency magnetic field may be cut off. In this way, generation of eddy current effect in the shielding body is suppressed. In this way, a surrounding magnetic field is not distorted or is slightly distorted. This slightly affects the detection result of the TMR element 320.

Preferably, in the shielding assembly 330, a shorter side length of the teeth and a shorter distance between the teeth indicate better suppression of the generation of eddy current effect in the shielding assembly 330, and small impact on the detection result of the TMR element 320.

In this application, the shielding assembly 330 is not limited to the structure shown in FIG. 9, and may be of another shape, for example, a semicircle shape. The shielding assembly 330 may cover the TMR element 320. In addition, there is a gap between the TMR element 320 and the shielding assembly 330, to avoid a case in which the magnetic field generated by the target trace 311 is shielded and the TMR element 320 cannot detect the magnetic field generated by the target trace 311. The shielding assembly 330 may be of another shape. This is not limited in this application. An embodiment of this application further provides an electronic device. The electronic device includes at least one magnetic sensor recited in FIG. 3 to FIG. 9 and the corresponding claimed solutions. Because the electronic device includes the magnetic sensor, the electronic device has all or at least some advantages of the magnetic sensor. The electronic device may be an electric vehicle, a computer, or the like.

In the descriptions of this specification, the described specific features, structures, materials, or characteristics may be combined in a proper manner in any one or more of embodiments or examples.

Finally, it should be noted that the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

**Claims**

1. A magnetic sensor, comprising:

   a printed circuit board (310), comprising a target trace (311) configured to electrically connect components to each other; and
   a tunnel magneto-resistance element (320), fastened to an outer surface of the printed circuit board and configured to detect a current value in the target trace, wherein
   the tunnel magneto-resistance element is located on a normal line on a side surface of the target trace, a ratio of a distance D between a detection unit in the tunnel magneto-resistance element and an edge on a side that is of the target trace and that is closest to the tunnel magneto-resistance element to a width W of the target trace is between 3.0% and 20.0%, the detection unit is configured to detect magnetic induction intensity, and the width of the target trace is a length in a direction perpendicular to a current flow direction on the target trace.

2. The magnetic sensor according to claim 1, wherein the distance D between the detection unit in the tunnel magneto-resistance element and the edge on the side that is of the target trace and that is closest to the tunnel magneto-resistance element satisfies:

$$D = 0.1584W - 0.1209,$$

   wherein
   D and W are in units of mm.

3. The magnetic sensor according to claim 1 or 2, wherein a width of the tunnel magneto-resistance element is less than the width of the target trace, and the width of the tunnel magneto-resistance element is a length in the direction perpendicular to the current flow direction on the target trace.

4. The magnetic sensor according to any one of claims 1 to 3, wherein the width w of the tunnel magneto-resistance element satisfies:

$$w < W - 2D,$$

   wherein
   D and W are in units of mm.

5. The magnetic sensor according to any one of claims 1 to 4, wherein in a direction of the normal line on the side surface of the target trace, a distance between the tunnel magneto-resistance element and the target trace is greater than zero.

6. The magnetic sensor according to any one of claims 1 to 5, wherein the target trace is made of a graphite material.

7. The magnetic sensor according to any one of claims 1 to 6, further comprising:
   a shielding assembly (320), disposed on a surface of a side that is of the tunnel magneto-resistance element and that is away from the printed circuit board, and configured to shield magnetic fields generated by a trace other than the target trace and another component.

8. The magnetic sensor according to claim 7, wherein the shielding assembly is of a comb structure.

9. The magnetic sensor according to claim 7 or 8, wherein a size of the shielding assembly is greater than a size of the tunnel magneto-resistance element.

10. An electronic device, comprising at least one magnetic sensor according to claims 1 to 9.

Low Frequency
(a)

High Frequency
(b)

FIG. 1

FIG. 2

Detection
point

320

W

T
D

311

Detection point

330

320

310

h

311

FIG. 3

FIG. 4

FIG. 5(a)

FIG. 5(b)

FIG. 6

FIG. 7

FIG. 8

FIG. 9

## INTERNATIONAL SEARCH REPORT

International application No.

**PCT/CN2022/103840**

### A.　CLASSIFICATION OF SUBJECT MATTER

G01R 33/02(2006.01)i;　G01R 33/09(2006.01)i

According to International Patent Classification (IPC) or to both national classification and IPC

### B.　FIELDS SEARCHED

Minimum documentation searched (classification system followed by classification symbols)

　　G01R

Documentation searched other than minimum documentation to the extent that such documents are included in the fields searched

Electronic data base consulted during the international search (name of data base and, where practicable, search terms used)

　　CNTXT; CNKI; CJFD; ENTXT; ENTXTC; VEN: 华为数字能源技术有限公司, 隧穿, 隧道, 磁, 传感器, TMR, 电流传感器, 印刷电路板, 印刷基板, 电路板, PCB, 布线, 走线, 导线, 导体, 宽度, 距离, 间距, 屏蔽, 梳状, 梳齿, 微安, μA, tunnel+, magnetoresistnace, weak, current, sensor, shield+, comb

### C.　DOCUMENTS CONSIDERED TO BE RELEVANT

| Category* | Citation of document, with indication, where appropriate, of the relevant passages | Relevant to claim No. |
|---|---|---|
| PX | CN 114252814 A (HUAWEI DIGITAL ENERGY TECHNOLOGY CO., LTD.) 29 March 2022 (2022-03-29)<br>　　claims 1-10 | 1-10 |
| X | CN 1898574 A (KONINKL PHILIPS ELECTRONICS N.V.) 17 January 2007 (2007-01-17)<br>　　description, page 3, lines 9-13 and page 18, line 19-page 19, line 12, and figure 12 | 1, 3, 5-6, 10 |
| Y | CN 1898574 A (KONINKL PHILIPS ELECTRONICS N.V.) 17 January 2007 (2007-01-17)<br>　　description, page 3, lines 9-13 and page 18, line 19-page 19, line 12, and figure 12 | 7-9 |
| Y | JP 2002082136 A (YAZAKI CORP.) 22 March 2002 (2002-03-22)<br>　　description, paragraphs 0110 and 0117-0118 | 7, 9 |
| Y | CN 110192116 A (MITSUBISHI ELECTRIC CORP.) 30 August 2019 (2019-08-30)<br>　　claim 1 | 8 |
| A | CN 112834805 A (CHINA ELECTRIC POWER RESEARCH INSTITUTE CO., LTD.) 25 May 2021 (2021-05-25)<br>　　entire document | 1-10 |
| A | JP 2013104774 A (RICOH CO., LTD.) 30 May 2013 (2013-05-30)<br>　　entire document | 1-10 |

☑ Further documents are listed in the continuation of Box C.　☑ See patent family annex.

| | |
|---|---|
| *　Special categories of cited documents:<br>"A"　document defining the general state of the art which is not considered to be of particular relevance<br>"E"　earlier application or patent but published on or after the international filing date<br>"L"　document which may throw doubts on priority claim(s) or which is cited to establish the publication date of another citation or other special reason (as specified)<br>"O"　document referring to an oral disclosure, use, exhibition or other means<br>"P"　document published prior to the international filing date but later than the priority date claimed | "T"　later document published after the international filing date or priority date and not in conflict with the application but cited to understand the principle or theory underlying the invention<br>"X"　document of particular relevance; the claimed invention cannot be considered novel or cannot be considered to involve an inventive step when the document is taken alone<br>"Y"　document of particular relevance; the claimed invention cannot be considered to involve an inventive step when the document is combined with one or more other such documents, such combination being obvious to a person skilled in the art<br>"&"　document member of the same patent family |

| Date of the actual completion of the international search | Date of mailing of the international search report |
|---|---|
| **22 September 2022** | **28 September 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2022/103840**

**C.  DOCUMENTS CONSIDERED TO BE RELEVANT**

| Category* | Citation of document, with indication, where appropriate, of the relevant passages | Relevant to claim No. |
|---|---|---|
| A | US 2013214776 A1 (HOLMAN PERRY et al.) 22 August 2013 (2013-08-22)<br>entire document | 1-10 |
| A | JP 2013113757 A (RICOH CO., LTD.) 10 June 2013 (2013-06-10)<br>entire document | 1-10 |

Form PCT/ISA/210 (second sheet) (January 2015)

INTERNATIONAL SEARCH REPORT

Information on patent family members

International application No.

**PCT/CN2022/103840**

| Patent document cited in search report | | | Publication date (day/month/year) | Patent family member(s) | | | Publication date (day/month/year) |
|---|---|---|---|---|---|---|---|
| CN | 114252814 | A | 29 March 2022 | None | | | |
| CN | 1898574 | A | 17 January 2007 | KR | 20060118560 | A | 23 November 2006 |
| | | | | US | 2007063690 | A1 | 22 March 2007 |
| | | | | DE | 602004011995 | D1 | 03 April 2008 |
| | | | | WO | 2005064356 | A2 | 14 July 2005 |
| | | | | AT | 386949 | T | 15 March 2008 |
| | | | | TW | 200533928 | A | 16 October 2005 |
| | | | | JP | 2007520057 | A | 19 July 2007 |
| | | | | EP | 1706751 | A2 | 04 October 2006 |
| JP | 2002082136 | A | 22 March 2002 | None | | | |
| CN | 110192116 | A | 30 August 2019 | JP | 6463560 | B2 | 06 February 2019 |
| | | | | DE | 112017006917 | T5 | 02 October 2019 |
| | | | | WO | 2018139123 | A1 | 02 August 2018 |
| | | | | US | 2019293729 | A1 | 26 September 2019 |
| CN | 112834805 | A | 25 May 2021 | None | | | |
| JP | 2013104774 | A | 30 May 2013 | None | | | |
| US | 2013214776 | A1 | 22 August 2013 | None | | | |
| JP | 2013113757 | A | 10 June 2013 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111360274